# EUROPEAN PATENT APPLICATION

(11) **EP 2 164 310 A1**
(43) Date of publication of application: **17.03.2010**
(21) Application number: 08765287.1
(22) Date of filing: 06.06.2008
(51) Int. Cl.: H05K 1/14, G02F 1/1345, G09F 9/00

(54) **DISPLAY MODULE, LIQUID CRYSTAL DISPLAY DEVICE AND METHOD FOR MANUFACTURING DISPLAY MODULE**

(30) Priority: 04.07.2007 JP 2007176701
(71) Applicant: Sharp Kabushiki Kaisha, Osaka-shi, Osaka 545-8522 (JP)
(72) Inventor: MINAMINO, Kohji, OSAKA 545-8522 (JP); KUSAKAI, Suguru, OSAKA 545-8522 (JP); KAWAGUCHI, Hisao, OSAKA 545-8522 (JP)
(74) Representative: Müller-Boré & Partner Patentanwälte
(86) International application number: PCT/JP2008/060474
(87) International publication number: WO 2009/004894

(57) **Abstract**

A liquid crystal display module (10) in accordance with the present invention includes a liquid crystal display module provided with a liquid crystal display panel (11), an external circuit substrate (13) and a film-shaped flexible print substrate (14) connected to an edge of the circuit substrate. In the liquid crystal display module, a source driver 1C (21) is mounted, by COF mounting, between a TFT substrate (17) and an external circuit substrate (13). In the flexible print substrate (14), a connector (22) to connect together an external connection terminal (24) on the external circuit substrate (13) and an external connection terminal (23) on the flexible print substrate (14) is provided. The connector (22) is furnished so as to sandwich an edge of the external circuit substrate (13). This way, it is possible to conduct a connection of the circuit substrate and of the flexible substrate easily, and to achieve a complete automation of the assembly line.

## Description

### Technical Field

The present invention relates to a display module including a display panel, a display panel driving circuit such as a driver integrated circuit, and a film-shaped flexible substrate connected to an edge portion of the display panel; as well as to a method for manufacturing the same.

### Background Art

Flat-panel display devices such as liquid crystal display devices are configured so as to include a display area in which an image is displayed and a peripheral area around the display area. The display area is the area in which the image is displayed, and the area in which a display medium causing an electro-optical effect or an electroluminescent effect (such as a liquid crystal layer in the case of a liquid crystal display device, or an EL layer in the case of an EL display device) is provided. Further, in the display area, electric wirings disposed in a matrix disposition are present in order to transmit a display signal to the display medium. "Peripheral area" refers to an area external to the display area, in which peripheral electric wirings necessary for display, such as extraction electrodes of the electric wiring disposed in a matrix disposition, are provided.

In general, drivers IC (semiconducting devices (components)) to drive the display device are directly mounted in the peripheral area through a TCP (Tape Carrier Package) mounting system.

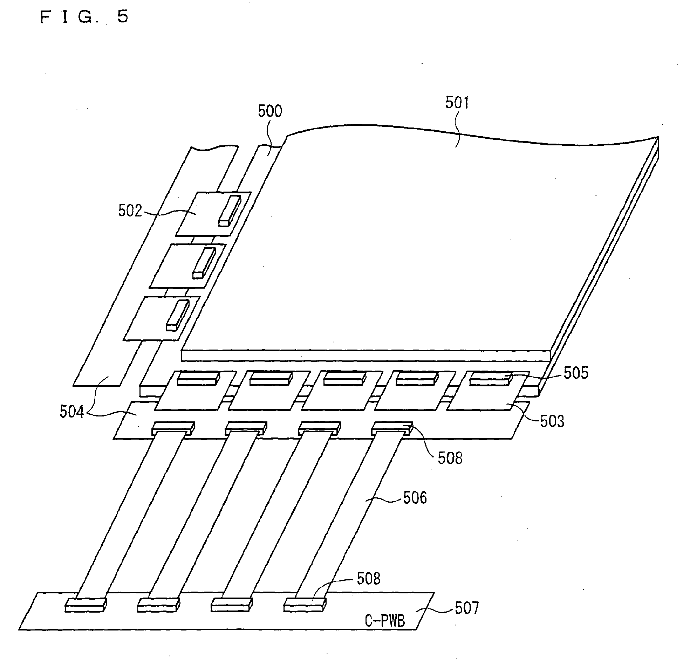

To illustrate an example of the above, Fig. 5 is a schematic view of a liquid crystal display module to which a driver IC is connected through the TCP mounting system.

In the display area on a TFT substrate 500 of the liquid crystal display module as illustrated in Fig. 5, a signal wiring (gate wiring, source wiring) not shown on the drawing is disposed in a matrix disposition. In addition, an opposing substrate 501 is provided on the signal wiring so as to cover the display area. An area on the TFT substrate 500 not covered by the opposing substrate 501 is the peripheral area. Furthermore, an external circuit substrate 504 (i.e. printed wiring board or PWB), used to supply the external signal, is disposed on an external side of the peripheral area. Further, on the peripheral area and on the external circuit substrate 504, a plurality of TCPs (source TCP (or COF) 502, or gate TCP 503), used to supply the signal to the signal wiring on the display area and having a driver IC 505, are provided so as to connect the peripheral area and the external circuit substrate 504.

In addition, a flexible substrate 506 (i.e. flexible printed circuit or FPC) is connected through a connector (CN) 508 to the external circuit substrate 504. Similarly, a controller substrate (i.e. controller printed wiring board or C-PWB) 507 having a liquid crystal controller is connected through the connector 508 to the other edge of the flexible substrate 506. Only a part of the flexible substrate is shown on Fig. 5.

Regarding the technology to solder and mount electronic components on the substrates, Patent Literature 1 and 2 disclose for example electronic circuit devices on which a sealing resin package (electronic component) is soldered and mounted on an insulating wiring substrate.

### Citation List

Patent Literature 1
   Japanese Patent Application Publication, Tokukaihei, No. 7-111278 (Publication Date: April 25, 1995)
Patent Literature 2
   Japanese Patent Application Publication, Tokukai, No. 2003-86634 (Publication Date: March 20, 2003)
Patent Literature 3
   Japanese Patent Application Publication, Tokukaihei, No. 8-278339 (Publication Date: October 22, 1996)

### Summary of Invention

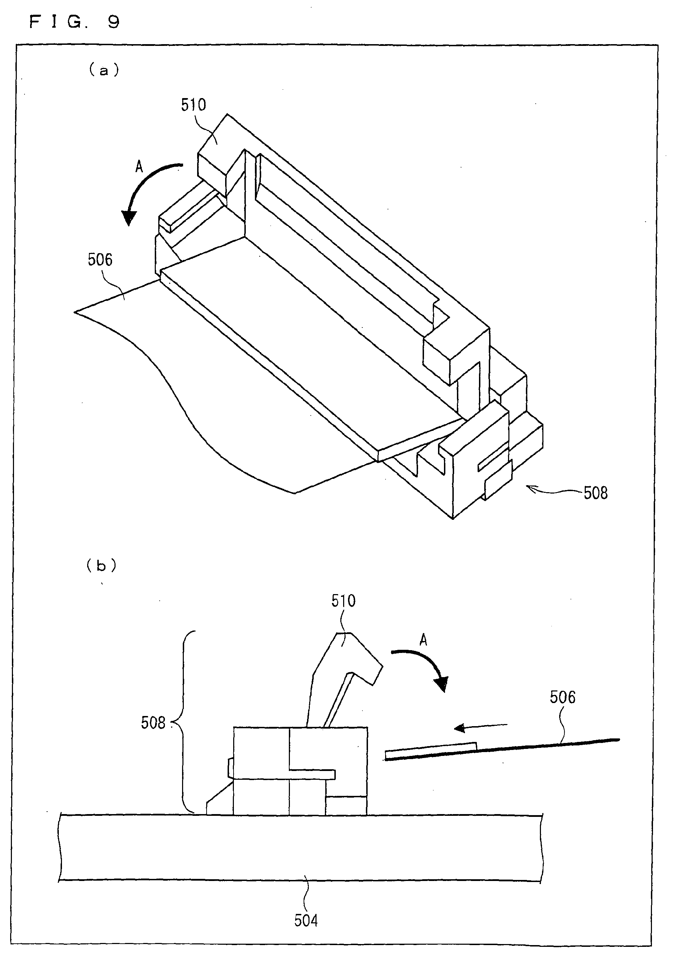

The connection of the flexible substrate to the connector is, for example, achieved as shown on (a) and (b) of Fig. 9. (a) and (b) of Fig. 9 show a configuration of a connecting part for connecting the connector 508 to the flexible substrate 506. As shown on (a) and (b) of Fig. 9, the connection of the flexible substrate to the connector is achieved by making a top cover 510, used as an actuator, rotate in a direction of an arrow A after inserting the flexible substrate 506 into the connector 508, so as to sandwich the flexible substrate 506 between the external circuit substrate 504 and the top cover 510. Because the automation of the above-described sandwiching of the flexible substrate is difficult, it must be undertaken manually.

The necessity to involve the above-described manual operation makes it impossible to achieve the complete automation of the manufacturing process of a display module, for example from connection (process) of a display panel and of the circuit substrate (such process including the mounting of a driver IC to the display panel), mounting inspection, to assembling of the module, i.e. connection of the PWB and of the flexible substrate. In other words, in the above-described manufacturing process of a display module, (i) the mounting inspection following the mounting of the IC driver on the display panel and (ii) the subsequent connection of the PWB to the flexible substrate must be conducted manually, due to the fact that they require the use of connectors as described above.

The necessity to conduct manually these operations results in an increase of the manufacturing cost, especially in the case of large-sized display panels including a higher number of connectors.

Further, when connecting a circuit substrate including such a connector structure to the flexible substrate, such a problem also occurs that fragility of the connectors causes a high defective ratio in the process.

The present invention is attained in view of the above-described problems. An object of the present invention is to provide a display module configuration by which it is possible to easily connect together a circuit substrate and a flexible substrate, and possible to achieve the complete automation of the assembly line and the automation of the mounting inspection following the connection of a display panel, a driver IC and a PWB.

In order to solve the above mentioned problems, a display module in accordance with the present invention includes a display panel, a circuit substrate including a display panel driving circuit and a film-shaped flexible substrate connected to an edge of the circuit substrate, wherein the flexible substrate includes a connector to connect a terminal on the flexible substrate with a terminal on the circuit substrate, the connector being furnished so as to sandwich the edge of the circuit substrate.

The display module in accordance with the present invention differs from conventional display modules in that the connector, which is provided not on the circuit substrate but rather on the flexible substrate, is furnished so as to sandwich the edge of the circuit substrate.

As a result, it is possible to connect together the circuit substrate and the flexible substrate simply by inserting the flexible substrate on which the connector is furnished into the edge of the circuit substrate on which the terminal is formed.

This way, it becomes possible to achieve on an automated assembly line the connection work, which was conventionally conducted manually.

Further, with a display module including this configuration, no connector is furnished on the substrate. As a result, it is not necessary, even during the mounting inspection of the circuit substrate conducted before furnishing the flexible substrate, to connect through the connector the terminal for the mounting inspection to the terminal on the circuit substrate. The mounting inspection of the circuit substrate in this configuration can be undertaken easily by using a mounting inspection device as disclosed in Patent Literature 3 or by using a contact-pin-type mounting inspection device conducting the inspection by putting a probe in contact with the terminal of the circuit substrate.

In the case of a conventional circuit substrate on which a connector was connected through soldering, it was necessary to undertake the mounting inspection manually. However, with the circuit substrate included in the display module in accordance with the present invention, it is possible to achieve an automatic inspection using a contact-pin-type inspection device.

Accordingly, with the display module according to the above configuration, it becomes possible to achieve a complete automation of the assembly line for all steps of the manufacturing process of a display module such as connection (process) of a display panel and of the circuit substrate (such process including the mounting of a driver IC to the display panel); mounting inspection; assembling of the module (i.e. connection of the circuit substrate and of the flexible substrate).

Further, when connecting a circuit substrate including a conventional soldered connector and a flexible substrate, there is the disadvantage that the ratio of process failure is high, due to the fact that the connector breaks easily. However, with the configuration in accordance with the present invention, it is possible to restrain the occurrence of such failures.

In this case, the fact that the connector is described as being provided on the flexible substrate does not refer only to a situation in which the connector is connected to the flexible substrate through caulking or soldering so as to be both non-attachable and irremovable. It also refers to a situation in which the connector is connected to the flexible substrate so as to be both attachable and removable.

In addition, with the circuit substrate in accordance with the present invention, it is not necessary to solder the connector. Accordingly, it is not necessary that a material used for each of the components provided on the substrate have a high heat resistance. As a result, the range of utilizable materials widens, and a higher number of materials can be adopted for the manufacture of the component.

With the display module in accordance with the present invention, the edge of the circuit substrate preferably has at least one incision to insert the connector.

With this configuration, because the position to insert the connector is determined by the incision the terminal on the circuit substrate and the terminal on the flexible substrate can be connected together without being positionally mismatched from each other. Therefore, it is possible to easily position the circuit substrate and the flexible substrate with regard to each other, and it is therefore possible to increase the reliability of the display module.

With the display module in accordance with the present invention, the edge of the circuit substrate preferably has a projection section to insert the connector, the projection section preferably having a surface on which the terminal is formed.

With this configuration, because the position to insert the connector is determined by the projection section, the terminal on the circuit substrate and the terminal on the flexible substrate can be connected together without being positionally mismatched from each other. Therefore, it is possible to easily position the circuit substrate and the flexible substrate with regard to each other, and it is therefore possible to increase the reliability of the display module.

With the display module in accordance with the present invention, the circuit substrate is preferably an external circuit substrate disposed alongside the display panel.

With this configuration, the present invention can be applied to a display module including an external circuit substrate, such as a TCP mounting system, a COF mounting system or the like.

With the display module in accordance with the present invention, the terminal on the circuit substrate is preferably plated with metal on its surface.

With this configuration, it is possible to increase the connection reliability of the connector and of the terminal on the circuit substrate.

With the display module in accordance with the present invention, the display panel is preferably a liquid crystal display panel comprising a liquid crystal display element.

With this configuration, it is possible to apply the display module in accordance with the present invention to a liquid crystal display device.

With the display module in accordance with the present invention, the liquid crystal display panel may be an active-matrix liquid crystal display device, and the circuit substrate may be a circuit substrate for source drivers.

In order to solve the above described problems, the liquid crystal display device in accordance with the present invention includes the display module and a backlight.

Because the liquid crystal display device in accordance with the present invention is provided with a display module such as the one described above, it is possible to undertake every step of the process (i.e. the process of connecting together the display panel, the circuit substrate and the flexible substrate, such process including the mounting inspection) on a completely automated assembly line. As a result, it is possible to reduce the manufacturing cost.

With the display module in accordance with the present invention, it is preferable that the display panel be any of the following: a SED panel comprising a surface conductive electron discharge element, a plasma display panel comprising a plurality of discharge cells, and an organic EL display panel comprising an organic electroluminescent element.

According to the above configuration, a thin display device (such as a SED display device, a plasma display device and an organic EL display device) can be adapted to the display module in accordance with the present invention.

A manufacturing method of the display module in accordance with the present invention is a manufacturing method of a display module including: a display panel; a circuit substrate including a display panel driving circuit; and a film-shaped flexible substrate connected to an edge of the circuit substrate, the manufacturing method comprising: inspecting mounting of the circuit substrate, by contacting a terminal of a mounting inspection device with a terminal on the circuit substrate connected to the display panel; and after the step of inspecting, connecting the terminal on the circuit substrate with a terminal on the flexible substrate, by fitting a connecter of the flexible substrate to an edge of the circuit substrate.

In the manufacturing method of the display module in accordance with the present invention, the connector to connect the flexible substrate and the circuit substrate is provided on the side of the flexible substrate. This makes it possible to connect easily the terminal of the circuit substrate and the terminal used for inspection purposes of the mounting inspection device. Accordingly, this makes it possible to conduct the mounting inspection on an automated assembly line, without any human intervention.

Further, the connector connecting the circuit substrate and the flexible substrate is furnished so as to sandwich the edge of the circuit substrate. This makes it possible to connect the circuit substrate and the flexible substrate through a simple operation such as inserting the connector into the edge of the circuit substrate.

Accordingly, with the above manufacturing method, it becomes possible to achieve a complete automation of the assembly line for all steps of the assembly of the display module such as connection of the display module to the circuit substrate; mounting inspection; and connection of the circuit substrate to the flexible substrate.

In the above manufacturing method of the display module in accordance with the present invention, the mounting inspection, in the step of inspecting, is preferably conducted by using a contact-pin-type mounting inspection device.

In the above manufacturing method, putting a probe of the contact-pin-type mounting inspection device into contact with each terminal on the circuit substrate makes it possible to easily conduct the mounting inspection.

A fuller understanding of the other objectives, characteristics and merits of the present invention can be obtained through the ensuing detailed description. Further, the advantages of the present invention will become obvious by referring to the following description taken in conjunction with the accompanying drawings.

### Brief Description of Drawings

Fig. 1

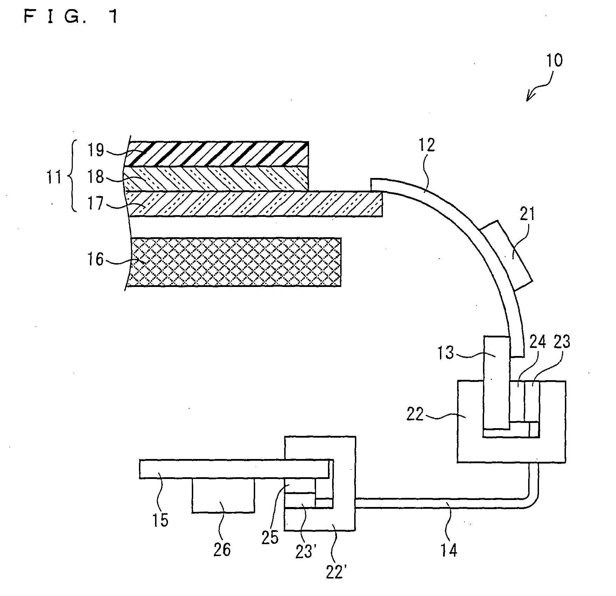

   Fig. 1 is a cross-sectional view illustrating a configuration of a liquid crystal display device in accordance with an embodiment of the present invention.
Fig. 2

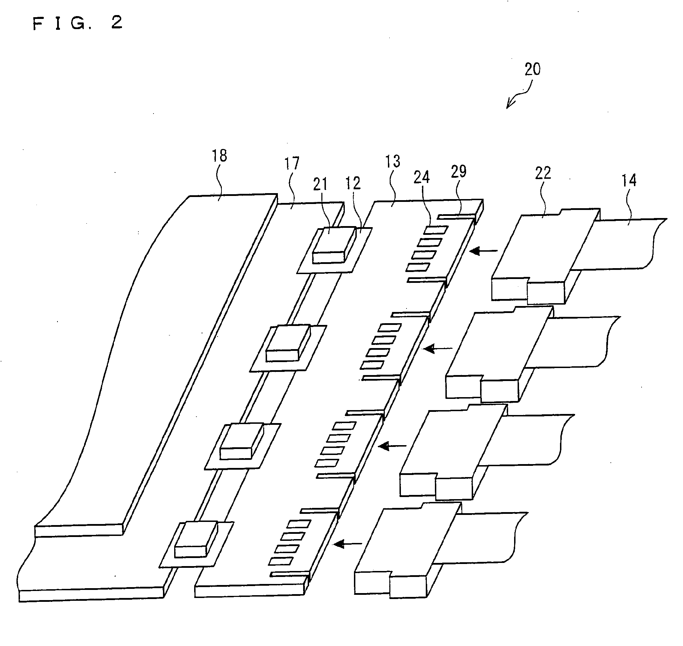

   Fig. 2 is a perspective view of a configuration of a liquid crystal display module in accordance with an embodiment of the present invention.
Fig. 3

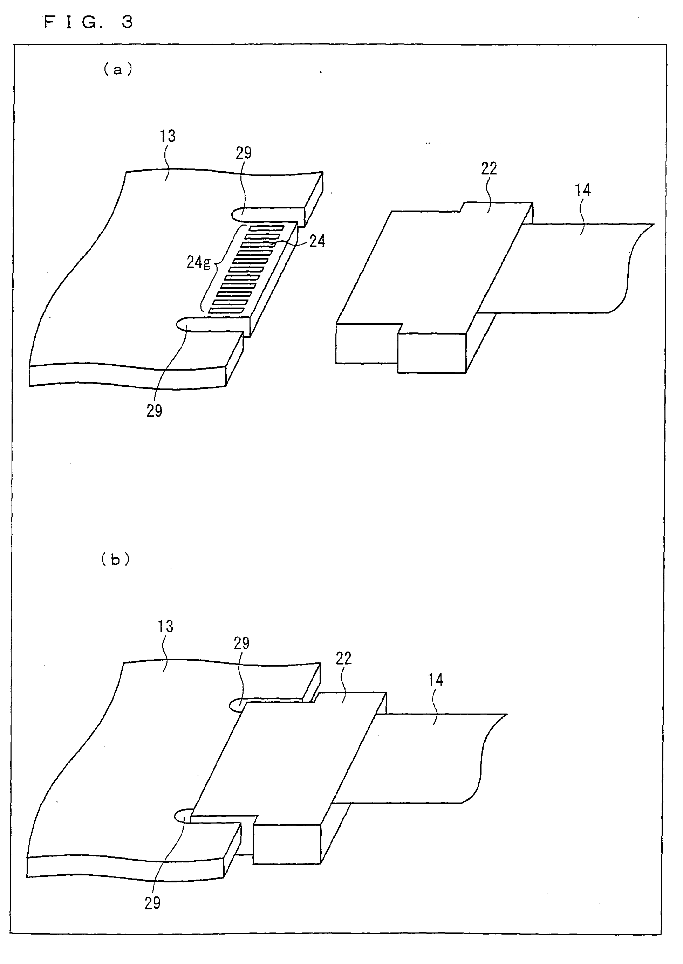

   Fig. 3 shows more concretely a configuration of a connecting part for connecting an external circuit substrate to a connector in the liquid crystal display device shown on Fig. 2. (a) of Fig. 3 shows the configuration when the external circuit substrate and the connector are separated from each other, and (b) of Fig. 3 shows the configuration when the external circuit substrate and the connector are connected to each other.
Fig. 4

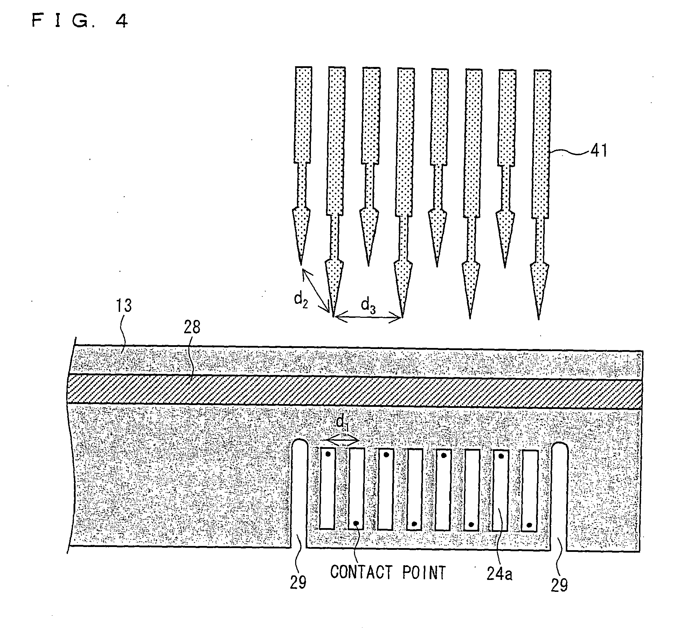

   Fig. 4 is a schematic view illustrating how a mounting inspection is conducted for the external circuit substrate.
Fig. 5
   Fig. 5 is a perspective view of a conventional TCP mounting system liquid crystal display module.
Fig. 6

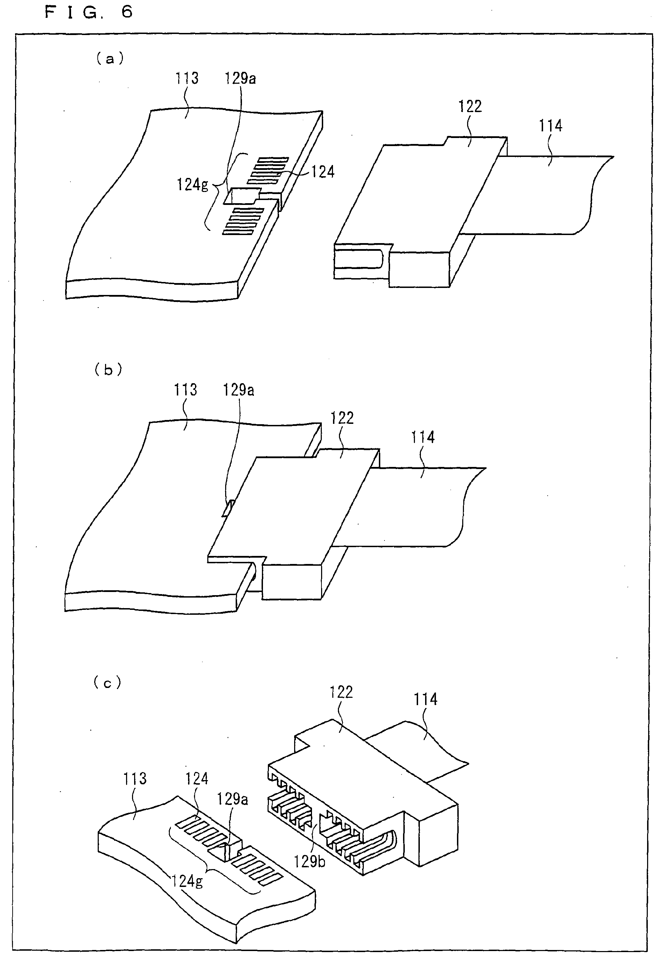

   Fig. 6 shows another example of the connecting part for connecting the external circuit substrate to the connector in the liquid crystal display device shown on Fig. 2. (a) of Fig. 6 shows the configuration when the external circuit substrate and the connector are separated from each other, and (b) of Fig. 6 shows the configuration when the external circuit substrate and the connector are connected to each other. Further, (c) of Fig. 6 shows from a different point of view the external circuit substrate and the connector shown in (a) of Fig. 6.
Fig. 7

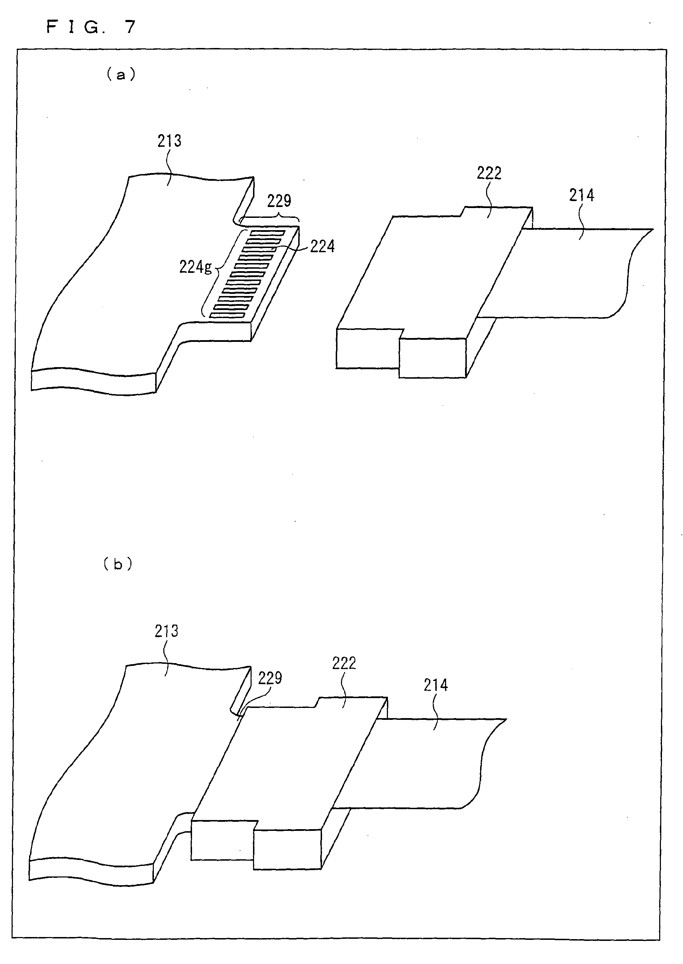

   Fig. 7 shows another example of the connecting part for connecting the external circuit substrate to the connector in the liquid crystal display device shown on Fig. 2. (a) of Fig. 7 shows the configuration when the external circuit substrate and the connector are separated from each other, and (b) of Fig. 7 shows the configuration when the external circuit substrate and the connector are connected to each other.
Fig. 8

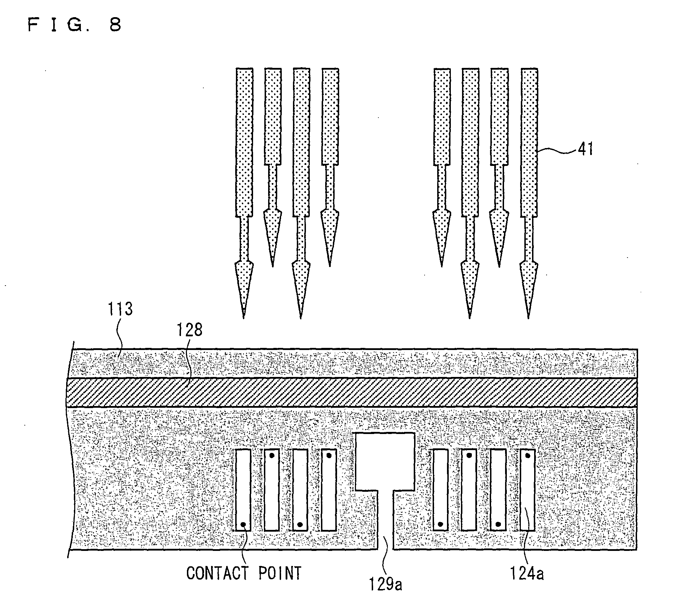

   Fig. 8 is a schematic view illustrating how a mounting inspection is conducted for the external circuit substrate shown on (a) of Fig. 6.
Fig. 9
   Fig. 9 shows an example of a configuration of a connecting part for connecting a connector to a flexible substrate in a conventional liquid crystal display module. (a) of Fig. 9 is a perspective view illustrating how the flexible substrate is furnished to the connector, and (b) of Fig. 9 is a lateral view illustrating how the flexible substrate is inserted into the connector provided on the external circuit substrate.

### Reference Signs List

- 10: Liquid crystal display device
- 11: Liquid crystal display panel (display panel)
- 12: COF
- 13: External circuit substrate (circuit substrate)
- 14: Flexible print substrate (flexible substrate)
- 20: Liquid crystal display module (display module)
- 22: Connector
- 22': Connector
- 23: External connection terminal (terminal)
- 24: External connection terminal (terminal)
- 29: Incision
- 41: Probe

### Description of Embodiments

One embodiment of the present invention is described below with reference to the attached drawings Figs. 1 to 4. However, the present invention is not limited to this embodiment.

This embodiment of the display module in accordance with the present invention will be described by taking, as an example, a liquid crystal display device provided with a COF mounting system (Chip on film) liquid crystal display module.

Fig. 1 illustrates a cross-sectional configuration of a liquid crystal display device 10 in accordance with the present embodiment of the present invention. The liquid crystal display device 10 in accordance with the present embodiment of the present invention includes an active-matrix-shaped liquid crystal display panel 11. The vicinity of an edge of the liquid crystal display panel on which source drivers are provided is partially shown on Fig. 1. Further, Fig. 2 illustrates a configuration of a liquid crystal display module (display module) 20 included in the liquid crystal display device 10. For the sake of convenience, the liquid crystal display panel 11, an external circuit substrate (PWB) 13 and a flexible print substrate (FPC) 14 are illustrated as being disposed on the same plane in Fig. 2.

As shown on Fig. 1, the liquid crystal display device 10 includes the liquid crystal display panel 11 and a backlight 16 provided on the back of the liquid crystal display panel 11. Further, the external circuit substrate (PWB) 13 is connected to the liquid crystal display panel 11. In addition, the external circuit substrate 13 is connected, through the flexible print substrate (FPC) 14, to a controller substrate (C-PWB) 15 on which a liquid crystal controller IC 26 is disposed.

The liquid crystal display panel 11 includes: a TFT substrate 17, on which TFT elements are provided in row; a color-filter substrate 18 provided in opposition to the TFT substrate 17; and a polarizer 19 disposed on the color-filter substrate 18. The polarizer 19 is omitted on Fig. 2.

As shown on Figs. 1 and 2, the liquid crystal display panel 11 is configured so that the TFT substrate 17 and the color-filter substrate 18 are assembled together, whereas a part of the TFT substrate 17 is exposed. Further, the liquid crystal display panel 11 includes a liquid crystal layer (not shown) disposed in a space between the above pair of substrates. The liquid crystal display panel 11 includes a display area, on which an image is displayed based on an image signal, and an area outside from the display area (i.e. a non-display area). The non-display area corresponds to a part of the TFT substrate 17 which the color-filter substrate 18 does not cover.

The TFT substrate 17 includes, on a glass substrate, scanning lines, a grid-shaped matrix wiring made from signal wiring, switch elements (TFT elements) provided per pixel, pixel electrodes and so on. A common electrode and a color-filter layer and the like are formed on the color-filter substrate 18. A plurality of gate driver ICs (not shown) administering a line-at-a-time scanning of the scanning lines (not shown) and a plurality of source driver ICs 21 supplying the image data signal to the signal wiring (not shown) are provided on the non-display area of the TFT substrate 17.

As shown on Figs. 1 and 2, in the present embodiment, the external circuit substrate (circuit substrate) 13 to supply an external signal is disposed, alongside the liquid crystal display panel 11, on the external side of the non-display area associated with the source driver ICs 21. Further, the source driver ICs (display panel driving circuits) 21 are mounted on a COF 12 disposed so as to connect between the non-display area of the liquid crystal display panel 11 and the external circuit substrate 13. This type of mounting is called the COF mounting system.

The COF mounting system is a mounting system where a COF (electronic component), provided with chips on a flexible substrate such as a polyimide film, is connected to the display panel. Because a general COF mounting, well known in this art, can be used in the present embodiment according to the present invention, explanation on the COF mounting will be omitted here.

Figs. 1 and 2 only show a part where the source driver ICs are mounted on the liquid crystal display panel 11 by COF mounting. However, the gate driver ICs are similarly mounted on the COF by COF mounting.

In the liquid crystal display module in accordance with the present embodiment, the driver ICs are mounted by COF mounting. However, in the present invention, it is possible to mount the driver ICs by TCP mounting, which is a mounting method similar to the COF mounting. The TCP mounting is a conventionally known type of mounting where a TCP (electronic component), provided with IC chips on a flexible material such as a polyimide film, is connected to the display panel.

A film of the COF 12 is made from a flexible material and is flexible. As a result, in the present embodiment in accordance with the present invention and as shown on Fig. 1, an edge of the COF 12 is connected to the edge of the TFT substrate 17, while another edge of the COF 12 is connected to the flexible substrate 14. The flexible substrate 14 is bent so as to be located under a backside of the TFT substrate 17.

While being connected with the COF 12 on one edge, the external circuit substrate 13 has a plurality of external connection terminals (terminals) 24 disposed alongside an edge opposing to this edge. The flexible print substrate 14, used for inputting the external signal, is connected to this edge along which the external connection terminals 24 are disposed.

The flexible print substrate 14 has the function of inputting, from outside into the liquid crystal display panel 11, a variety of electric signals necessary for display (image data signals and the like) and the electrical power supply to drive the driver ICs and others (i.e., electrical power voltage for IC driving, electrical power voltage for common electrode driving). In the present embodiment, the structure including the liquid crystal display panel (display panel) 11, the external circuit substrate (circuit substrate) 13 connected with the COF 12, and the flexible print substrate (flexible substrate) 14 is called a liquid crystal display module (display module) 20. Even though this is not shown on Fig. 2, a connection terminal, along with a wiring pattern to send a variety of signals, is formed on each of the components (liquid crystal display panel 11, external circuit substrate 13, flexible print substrate 14) included in the liquid crystal display module (display module) 20. The components are electrically connected with each other by contacting their respective connection terminals with each other.

The flexible print substrate 14 is made from a thin-film tape made of a polyimide resin and is therefore flexible. In the present embodiment, the flexible print substrate 14 is connected to the edge of the external circuit substrate 13. The flexible print substrate 14 is also bent in an L shape that is extended under a backside of the liquid crystal display device 11 and a backside of the backlight 16, and thereby extends under the liquid crystal display panel 11.

A controller substrate 15 (C-PWB), connected to the flexible print substrate 14, is provided under the backside of the external circuit substrate 13. A semiconductor integrated circuit such as the liquid crystal driver controller IC 26 is provided on the controller substrate 15. The liquid crystal driver controller IC 26 generates a variety of signals necessary to display an image on the liquid crystal display panel 11, and supplies the variety of signals through the flexible print substrate 14 to the source driver IC 21, the gate driver IC, and the like. The following is a more concrete explanation of a configuration of the flexible print substrate 14.

The flexible print substrate 14 is a film-shaped substrate, made from polyimide or a similar material. On the flexible print substrate 14, a plurality of wirings to send a variety of signals is formed. Terminals 23 and 23' (to achieve the electric connection with an external electronic component) and connectors 22 and 22' (to achieve the mechanical connection with an external electronic component) are provided respectively at the edges of the two sides on which the wirings are formed. The terminal 23 is connected electrically to the external connection terminal 24 of the external circuit substrate 13, and the terminal 23' is connected electrically to the external connection terminal 25 of the controller substrate 15.

Further, the connectors 22 and 22', furnished at both edges of the flexible print substrate 14, are furnished so as to sandwich an edge of the external circuit substrate 13 and of the controller substrate 15, as shown on Fig. 1.

This way, the display module in accordance with the present invention is configured such that the external circuit substrate does not have a connector to connect the external circuit substrate to the flexible print substrate, unlike the conventional technology. Instead, the flexible print substrate 14 has the connector 22.

Further, as shown on Fig. 2, the flexible print substrate 14 can be easily connected to the external circuit substrate 13 by inserting the flexible print substrate 14 in the direction of the arrows, because the flexible print substrate 14 is provided with a connector 22 designed to sandwich the edge of the substrate the flexible print substrate 14 is to be connected with. As a result, it is possible to conduct an automatic connection by using machines.

Further, with the circuit substrate in accordance with the present invention, it is not necessary to solder the connector 22. Accordingly, it is not necessary that a material used for the connector 22 have a high heat resistance. As a result, the variety of utilizable materials widens, and the component can be produced from a material selected from more choices.

As shown on Fig. 2, the present embodiment in accordance with the present invention is configured such that an incision 29 is formed on that edge of the external circuit substrate 13 along which the external connection terminals 24 are disposed, so as to correspond to the point of insertion of the connector 22.

Fig. 3 shows a more detailed configuration of the connecting parts of the external circuit substrate 13 and of the connector 22 provided on the liquid crystal display module 20 shown on Fig. 2. (a) of Fig. 3 shows the configuration when the external circuit substrate 13 and the connector 22 are separated from each other, and (b) of Fig. 3 shows the configuration when the external circuit substrate 13 and the connector 22 are connected to each other.

As shown on Fig. 3, by inserting appropriately the connector 22 of each flexible print substrate 14 into the corresponding incision 29, a group of external connection terminals 24g (a group of external connection terminals connected to a single connector 22) of the external circuit substrate 13 and the external connection terminal 23 of the flexible print substrate 14 are securely connected without causing positional mismatching between each other.

The surface of the external connection terminal 24 on the external circuit substrate 13 may be plated with metal. This gives a higher reliability to the connection of the connector 22 with the external connection terminal 24.

The following is an explanation of a manufacturing method in accordance with an embodiment of the present invention for the liquid crystal display device module.

First, each component included in the liquid crystal display module 20 (i.e. liquid crystal display panel 11, COF 12, external circuit substrate 13, flexible print substrate 14) is manufactured. Because the liquid crystal display panel 11 and the COF 12 can adopt configurations similar to conventional ones, the explanations related to their manufacturing methods will be omitted here.

The external circuit substrate 13 is identical to a conventional external circuit substrate except that the connector is not soldered to the external circuit substrate 13. In other words, the external circuit substrate 13 in the embodiment in accordance with the present invention can be manufactured by a conventional method from which the soldering process to manufacture a connector is omitted.

The connectors 22 and 22' included in the flexible print substrate 14 can be made from a resinous material such as plastic. As a result, a connector shaped as the connector shown on Figs. 2 and 3 may be manufactured by using a standard method to form plastic. Further, a film, for example made from polyimide, included in the flexible print substrate 14 can be manufactured by using a conventional method to manufacture a film.

The flexible print substrate 14 can therefore be manufactured by connecting the connectors 22 and 22' manufactured as above and a film. The connectors 22 and 22' manufactured as above and the film can be connected through a method such as pressure welding, caulking or soldering. However, the connecting method of the film and connectors included in the flexible print substrate in accordance with the present invention is not limited to the above, and the present invention may be arranged such that the film and the connectors are connected detachably.

When each component included in the liquid crystal display module 20 has been manufactured as above, the connection process of each component is conducted.

First, the liquid crystal display panel 11 and the external circuit substrate 13 are connected through the COF 12 by using the general COF mounting system.

Following the completion of the connection process, a probe of a contact-pin-type mounting inspection device is put in contact with the external connection terminal 24 on the external circuit substrate 13 connected to the liquid crystal display panel 11 through the COF 12. The mounting inspection of the external circuit substrate 13 is then conducted. The mounting inspection device may be a conventional mounting inspection device using a pin contact, or it may be an inspection device including a contact terminal as described in Patent Literature 3.

Fig. 4 shows how a mounting inspection conducted regarding the external circuit substrate 13 is conducted. As shown on Fig. 4, the mounting inspection is conducted by putting a probe 41 of the mounting inspection device in contact with each external connection terminal 24a on the external circuit substrate 13. Fig. 4 also shows a group of connection terminals 28, connected to the COF.

The probes 41 of the mounting inspection device are disposed in a staggered configuration (alternately), as shown on Fig. 4. In Fig. 4, points of contact of the probes 41 formed in staggered configuration are indicated on the rectangular external connection terminals 24a of the external circuit substrate 13. By disposing each probe 41 in a staggered configuration in this way, it is possible to make each probe 41 correspond to a narrow pitch between two adjoining external connection terminals 24b (for example, d1 = 0.45 mm to 0.9 mm). A pitch between two adjoining probes 41 in this example is as follows: d2 = 0.635 mm to 1.27 mm ; d3 = 0.9 mm to 1.8 mm.

As explained above, the external circuit substrate 13 included in the liquid crystal display module 20 in accordance with the present embodiment is such that the connectors on the external connection terminals 24 on the substrate are not mounted by soldering and thus are exposed. As a result, it is not necessary to manually connect the probes of the mounting inspection device to the external connection terminals 24, and the mounting inspection of the external circuit substrate 13 can be conducted on an automated assembly line.

Following the completion of the mounting inspection, the external connection terminal 24 on the external circuit substrate 13 and the external connection terminal 23 on the flexible print substrate 14 are connected by inserting into the external circuit substrate 13 the connectors 22 furnished on the edge of the flexible print substrate 14, as shown on Fig. 2.

Because the above-described connection process does not require complex operations such as in the case of conventional connectors connected by soldering on an external circuit substrate, the above-described connection process can be conducted on an automated assembly line by using machines.

As described above, regarding the manufacturing method in accordance with the present embodiment for manufacturing the liquid crystal display module, it becomes possible to achieve a complete automation of the assembly line for all steps of assembling a display module such as connection of the display panel to the COF (Chip on Film); connection of the COF to the PWB; mounting inspection; and assembling the module (connection of the PWB to the flexible substrate).

In the above-described embodiment, the incision 29 is formed at the edge of the external circuit substrate 13 in order to securely connect the external circuit substrate 13 and the connector 22 of the flexible print substrate 14. However, the present invention is not limited to such a configuration, and any configuration where a connector is provided so as to sandwich the edge of the external circuit substrate from above and below may be used.

Fig. 6 shows another example of a configuration of the display module in accordance with the present invention. (a) of Fig. 6 shows the configuration when an external circuit substrate 113 and a connector 122 are separated from each other, and (b) of Fig. 6 shows the configuration when the external circuit substrate 113 and the connector 122 are connected to each other. Further, (c) of Fig. 6 shows from a different point of view the external circuit substrate 113 and the connector 122 shown in (a) of Fig. 6 (the external circuit substrate 113 being in front).

In the display module shown on Fig. 3, two incisions 29 are formed in relation with one connector 22 to be connected to the external circuit substrate 13; however, in the display module shown on Fig. 6, one incision 129a is formed in relation with one connector 122 to be connected to the external circuit substrate 113. In the connector 122 shown on (a) of Fig. 6, the incision 129a is formed in a middle part of the group of external connection terminals 124g along in a direction in which the group of external connection terminals 124g are arranged. However, the present invention is not limited to such a configuration.

Further, in the connector 122, as shown on (c) of Fig. 6, an inserting section 129b is formed at a position corresponding to the position where the incision 129a is formed on the external circuit substrate 113. Further, as shown on (c) of Fig. 6, an upper member and lower member of a part of the connector 122 used to sandwich the external circuit substrate 113 are internally shaped like the teeth of a comb. In the upper side of the part shaped like the teeth of a comb, terminals are formed to connect with the external connection terminals 124.

The rest of the configurations regarding the display module shown on Fig. 6 being identical to the configurations of the liquid crystal display module 20 described by using

Figs. 2 and 3 etc., the explanations on the same matter will not be repeated.

The display module as shown on Fig. 6 is configured such that, by inserting appropriately the connector 122 of each flexible print substrate 114 in the corresponding incision 129a, a group of external connection terminals 124g (a single group of external connection terminals 124 connected to a single connector 122) on the side of the external circuit substrate 113 and the external connection terminal on the side of the flexible print substrate 114 are securely connected without causing positional mismatching between each other.

Fig. 8 shows an example of a mounting inspection conducted regarding the external circuit substrate 113 shown on (a) of Fig. 6. As shown on Fig. 8, the mounting inspection is conducted by putting a probe 41 of the mounting inspection device in contact with each external connection terminal 124a on the external circuit substrate 113. Fig. 8 also shows a group of connection terminals 128 that are to be connected to the COF.

Fig. 7 shows another example of a configuration of the display module in accordance with the present invention. (a) of Fig. 7 shows the configuration when the external circuit substrate 213 and the connector 222 are separated from each other, and (b) of Fig. 7 shows the configuration when the external circuit substrate 213 and the connector 222 are connected to each other.

In the display module shown on Fig. 3, the incision 29 is formed in relation with one connector 22 to be connected to the external circuit substrate 13. The external circuit substrate 13 and the connector 22 are connected by fitting a part of the connector 22 into the incision 29.

In contrast to the above, in the display module shown on Fig. 7, a projection section 229 is provided at the edge of external circuit substrate 213. A group of external connection terminals 224g (a group of external connection terminals 224 connected to a single connector 222) is formed on the surface of the projection section 229. Further, the external circuit substrate 213 is connected to the connector 222 by inserting the projection section 229 into the connector 222.

With this configuration, the group of external connection terminals 224g on the side of the external circuit substrate 213 and the external connection terminal 223 on the side of the flexible print substrate 214 are securely connected without causing positional mismatching.

The rest of the configurations regarding the display module shown on Fig. 7 being identical to the configurations of the liquid crystal display module 20 described by using Figs. 2 and 3 etc., the explanations on the same matter will not be repeated.

The present invention is not limited to these embodiments explained based on a liquid crystal display device provided with a liquid crystal display module as an example of the present invention. Other examples of the present invention include a display panel provided with any of the following: a SED display panel having a surface conductive electron discharge element, a plasma display panel having a plurality of electric discharge cells or an organic EL display panel having an organic electroluminescent element.

With this configuration, it is possible to adapt the display module in accordance with the present invention to a thin display device such as a SED display device, a plasma display device or an organic EL display device.

In this case, because a conventionally known configuration can be used for the above-mentioned SED display panel, for the above-mentioned plasma display device and for the above-mentioned organic EL display device, the related explications will be omitted.

The present invention is not limited to the above-described embodiments, and miscellaneous modifications are possible within the scope of the claims.

As described above, the display module in accordance with the present invention is provided with connectors, on the flexible substrate, to connect together the terminals on the circuit substrate and the terminals on the flexible substrate, the connectors being furnished so as to sandwich an edge of the circuit substrate.

Accordingly, it is possible to connect the circuit substrate and the flexible substrate through the simple operation of inserting the flexible substrate where the connectors are furnished into the terminals formed at the edge of the circuit substrate.

Further, with a display module having the above configuration, the connectors are not provided on the substrate. Consequently, it is not necessary, even when conducting the mounting inspection of the circuit substrate before furnishing the flexible substrate, to connect the terminals of a mounting inspection device to the terminals of a circuit substrate through the connectors. As a result, with the circuit substrate included in the display module in accordance with the present invention, it is possible to conduct an automatic inspection using a contact-pin technique.

As described above, with the display module according to the above configuration, it becomes possible to achieve a complete automation of the assembly line for all steps of the manufacturing process of a display module such as connection (process) of a display panel and of the circuit substrate (such process including the mounting of a driver IC to the display panel); mounting inspection; assembling of the module (i.e. connection of the circuit substrate to the flexible substrate).

The detailed explanations of the invention which were given above in connection with concrete embodiments and examples are merely intended to clarify the technical contents of the present invention. Such concrete embodiments and examples should not be interpreted in a restrictive sense only, and various modifications can be exercised within the spirit of the invention and the scope of the following claims.

### Industrial Applicability

With the display module in accordance with the present invention, every step of the process of connecting to one another a display panel, a circuit substrate and a flexible substrate, including a mounting inspection, can be conducted on a completely automated assembly line. As a result, the display module in accordance with the present invention can be used in the manufacture of liquid crystal display devices and the like.

## Claims

1. A display module including:
a display panel;
a circuit substrate including a display panel driving circuit; and
a film-shaped flexible substrate connected to an edge of the circuit substrate,
wherein the flexible substrate includes a connector to connect a terminal on the flexible substrate with a terminal on the circuit substrate, and
the connector is furnished so as to sandwich the edge of the circuit substrate.

2. The display module according to claim 1, wherein the edge of the circuit substrate has at least one incision to insert the connector.

3. The display module according to claim 1, wherein the edge of the circuit substrate has a projection section to be inserted into the connector, the projection section having a surface on which the terminal is formed.

4. The display module according to claim 1, wherein the circuit substrate is an external circuit substrate disposed alongside the display panel.

5. The display module according to claim 1, wherein the terminal on the circuit substrate is plated with metal on its surface.

6. The display module according to claim 1, wherein the display panel is a liquid crystal display panel comprising a liquid crystal display element.

7. The display module according to claim 6, wherein:
the liquid crystal display device is an active-matrix liquid crystal display device; and
the circuit substrate is a circuit substrate for source drivers.

8. A liquid crystal display device including a display module according to claim 6 and a backlight.

9. The display module according to claim 1, wherein the display panel is any of the following:
a SED panel comprising a surface conductive electron discharge element;
a plasma display panel comprising a plurality of discharge cells; and
an organic EL display panel comprising an organic electroluminescent element.

10. A manufacturing method of a display module including: a display panel; a circuit substrate including a display panel driving circuit; and a film-shaped flexible substrate connected to an edge of the circuit substrate, said manufacturing method comprising:
inspecting mounting of the circuit substrate, by contacting a terminal of a mounting inspection device with a terminal on the circuit substrate connected to the display panel; and
after the step of inspecting, connecting the terminal on the circuit substrate with a terminal on the flexible substrate, by fitting a connecter of the flexible substrate to an edge of the circuit substrate.

11. The manufacturing method according to claim 10, wherein in the step of inspecting, the mounting inspection is conducted by using a contact-pin-type mounting inspection device.
